# EUROPÄISCHE PATENTANMELDUNG

(11) **EP 1 278 071 A2**
(43) Veröffentlichungstag der Anmeldung: **22.01.2003**
(21) Anmeldenummer: 02016022.2
(22) Anmeldetag: 18.07.2002
(51) Int. Cl.: G01R 19/252, G01R 21/133

(54) **Einrichtung zur Messung des fliessenden elektrischen Stromes in mindestens einem elektrischen Leiter und Verfahren zur Fehlerkorrektur von solchen Einrichtungen**

(30) Priorität: 20.07.2001 DE 10136939; 20.07.2001 DE 20112483 U
(71) Anmelder: ENSECO GmbH, 81379 München (DE)
(72) Erfinder: Meyer, Gerhard, Dr.-Ing., 16356 Eiche (DE)
(74) Vertreter: Jacoby, Georg

(57) **Zusammenfassung**

Die Erfindung betrifft Einrichtungen zur Messung des fließenden elektrischen Stromes in mindestens einem elektrischen Leiter (2), der mit wenigstens einem elektrischen Verbraucher verbunden ist, und Verfahren zur Fehlerkorrektur von Einrichtungen zur Messung des fließenden elektrischen Stromes in mindestens einem elektrischen Leiter, der mit wenigstens einem elektrischen Verbraucher verbunden ist, und wobei die Messwerte in eine dem Messwert äquivalente elektrische Impulsfolge gewandelt werden. Diese zeichnen sich besonders durch die Möglichkeiten der Fehlerkorrektur und Kalibrierung aus.

Die Fehlerkorrektur basiert auf einer selbstlernenden Struktur in den Einrichtungen, wobei aus einer Korrekturtabelle der für die Einrichtung zutreffende oder nächstliegende Fehlerkorrekturwert bestimmt, ausgewählt und in eine Steuer- und Verarbeitungseinrichtung nichtveränderbar so übernommen wird, dass bei jeder Messung dieser Fehlerkorrekturwert während der aktuellen Messungen berücksichtigt wird. Dabei werden innerhalb eines festgelegten Zeitintervalls die Ausgangsimpulsfolge hinsichtlich ihrer Impulszahl in geeignet kleinen Iterationsschritten jeweils soviel Impulse der Eingangsimpulsfolge abgezogen oder hinzugefügt, dass eine nominelle Impulszahl gleich groß ist.

## Beschreibung

Die Erfindung betrifft Einrichtungen zur Messung des fließenden elektrischen Stromes in mindestens einem elektrischen Leiter, der mit wenigstens einem elektrischen Verbraucher verbunden ist, und Verfahren zur Fehlerkorrektur von Einrichtungen zur Messung des fließenden elektrischen Stromes in mindestens einem elektrischen Leiter, der mit wenigstens einem elektrischen Verbraucher verbunden ist, und wobei die Messwerte in eine dem Messwert äquivalente elektrische Impulsfolge gewandelt werden.

Stromzähler sind unter anderem als Ferrariszähler bekannt. Dabei läuft eine drehbar gelagerte Ankerscheibe aus Aluminium zwischen den Polen zweier Elektromagnete hindurch, von denen einer die Stromstärkespule und der andere die Spannungsspule trägt. Die Felder dieser Magneten bilden ein Wanderfeld aus, so dass die Ankerscheibe in Bewegung gesetzt wird. Ein Dauermagnet ruft ein Bremsmoment hervor. Die Umdrehungen der Scheibe sind der Arbeit proportional und werden durch ein Zählwerk angezeigt. Der Nachteil liegt in der bewegten Ankerscheibe, so dass ein lageunabhängiger Einbau eines solchen Zählers nicht möglich ist. Die Eichung kann erst nach Erreichen des dynamischen Betriebs erfolgen. Eine Manipulierbarkeit des Zählers ist nicht ausgeschlossen.
Eine erste Gruppe von Lösungen, die diese Nachteile vermeiden, sind einfach aufgebaute und nichteichfähige elektronische Energiezähler. Diese Stromkostenzähler dienen einer groben Erfassung des Verbrauchs an elektrischer Energie, z.B. der annähernden Messung des elektrischen Energieverbrauches eines Gerätes im Haushalt.
Eine derartige Lösung ist unter anderem in der DE OS 36 19 053 A1 (Stromkostenzähler) aufgeführt. Bei dieser Lösung erfolgt nur die Erfassung des Stromverbrauches über einen in die Zuleitung geschalteten Messwiderstand. Die stromäquivalente Spannung wird verstärkt, in eine äquivalente Frequenz umgesetzt und über einen Zähler einer Anzeige zugeführt. Mit dieser Lösung kann die verbrauchte Energie nur annähernd bestimmt werden.
Eine ähnliche Lösung ist in der DE OS 37 43 034 A1 (Elektrisches und/oder elektronisches Installationsgerät) zu finden. Hauptaugenmerk der beschriebenen Lösung gilt den einsatzfähigen Gehäusemöglichkeiten und nicht der Auswerteschaltung.
Eine zweite Gruppe elektronischer Energiezähler zeichnen sich durch ihre Eichfähigkeit aus. Ein derartiger Energiezähler ist unter anderem durch die DE OS 196 06 927.0 A1 (Elektronische Energiezähler) bekannt. Dabei werden ein stromäquivalenter Spannungswert, der an einem in die Phase geschalteten Widerstand anliegt, und die am Verbraucher anliegende Spannung gleichzeitig über zwei Analog-Digital-Umsetzer in jeweils ein digitales Signal umgesetzt. Über einen digitalen Multiplizierer und einen nachgeschalteten Leistungs-Frequenz-Wandler entsteht eine Impulsfolge, die dem Produkt der Spannungen äquivalent ist. Mit einer extern einstellbaren Referenzspannung ist die Eichfähigkeit dieser Messschaltung gegeben. Diese Impulsfolge wird unter anderem auf einen elektronischen Zähler geschalten, der mit einem Rollenzähler verkoppelt ist. Damit ist eine ständige Ablesbarkeit der verbrauchten Leistung gegeben. Die Referenzspannung muss für jeden Energiezähler separat eingestellt werden, so dass eine automatische Herstellung weitestgehend nicht möglich ist.
Hauptaugenmerk der DE OS 198 42 241 A1 (Elektrizitätszähler und Eingangsbaustein für einen Elektrizitätszähler) gilt einem hoch integrierten Eingangsbaustein, der universell für verschiedenste Anwendungen eingesetzt werden kann. Damit ist es möglich, für eine nachfolgende Signalverarbeitung standardmäßige Prozessoren oder digitale Signalprozessoren einzusetzen. Diese Prozessoren beinhalten Speicher, in denen Parameter und/oder Betriebseinstellungen und/oder sonstige für den Betrieb vorgeb- oder einstellbare Daten gespeichert oder speicherbar sind. Auf eine Wirkungsweise insbesondere der Daten der Parameter und/oder Betriebseinstellungen wird nicht näher eingegangen.
In der DE PS 197 13 120 C1 (Elektrizitätszähler) ist ein Elektrizitätszähler für Mehrphasennetze aufgeführt. Dabei werden die Spannungs- und Stromsignale über jeweils einen Signalkanal einer digitalen Signalverarbeitungseinrichtung zugeführt. Jeder der beiden Signalkanäle weist einen Multiplexer mit einem nachgeschalteten Analog- Digital- Wandler auf. Die Multiplexer dienen dem Zuschalten der zusammengehörigen Strom- und Spannungswerte der jeweiligen Phase, so dass ein einfacher Aufbau eines Mehrphasenzählers vorhanden ist. Auf eine Kalibrierung wird nicht näher eingegangen.
Der in den Patentansprüchen 1 und 7 angegebenen Erfindung liegt das Problem zugrunde, fehlerkorrigierte und kalibrierte Einrichtungen zur Messung des fließenden elektrischen Stromes und Verfahren zur Kalibrierung und Fehlerkorrektur von solchen Einrichtungen zu schaffen.

Dieses Problem wird mit den in den Patentansprüchen 1 und 7 aufgeführten Merkmalen gelöst.

Die Einrichtungen zur Messung des fließenden elektrischen Stromes in mindestens einem elektrischen Leiter, der mit wenigstens einem elektrischen Verbraucher verbunden ist, zeichnen sich besonders durch die Möglichkeiten der Fehlerkorrektur und Kalibrierung aus. Das basiert auf einer softwaregesteuerten und die Fehlerkorrektur und die Kalibrierung übernehmenden Steuer- und Verarbeitungseinrichtung. Dadurch ist es weiterhin möglich, die Fehler jeweils unabhängig von weiteren Anordnungen innerhalb des elektronischen Energiezählers zu kompensieren.
Die Fehlerkorrektur basiert auf einer selbstlernenden Struktur in den Einrichtungen selbst, wobei aus einer Korrekturtabelle der für die Einrichtung zutreffende oder nächstliegende Fehlerkorrekturwert bestimmt, ausgewählt und in die Steuer- und Verarbeitungseinrichtung nichtveränderbar so übernommen wird, dass bei jeder Messung dieser Fehlerkorrekturwert während der aktuellen Messungen berücksichtigt wird. Dabei werden innerhalb eines festgelegten Zeitintervalls die Ausgangsimpulsfolge hinsichtlich ihrer Impulszahl in geeignet kleinen Iterationsschritten jeweils soviel Impulse der Eingangsimpulsfolge abgezogen oder hinzugefügt, dass eine nominelle Impulszahl gleich groß ist. Um den Fehlerkorrekturwert zu ermitteln, ist keine Referenzeinrichtung sondern nur eine elektronische Quelle notwendig, die innerhalb der Kalibrierzeit einen virtuellen Wert hoher Konstanz besitzt. Damit ist die Fertigung der Einrichtungen ohne manuelle Eingriffe vollständig automatisierbar.
Dabei wird weder eine Verstellung noch eine andere Manipulation sondern nur ein innerer Softwarezuordnungsalgorithmus vorgenommen.
In eine Speichereinheit der Steuer- und Verarbeitungseinrichtung können auch weitere Daten eingeschrieben werden, die die Einrichtungen näher bestimmen und den aktuellen Stromfluss zuordnen, z.B. entsprechend verschiedener Tarife oder Lieferverträge von unterschiedlichen Anbietern.
Alle wichtigen Daten befinden sich in einem nichtflüchtigen Speicher des Speichers der Steuerund Verarbeitungseinrichtung, so dass bei einem Stromausfall die Daten nicht verloren gehen.
Die erfindungsgemäßen Einrichtungen zeichnen sich weiterhin dadurch aus, dass z.B. die Abnahme elektrischer Energie messtechnisch erfasst und lokal angezeigt werden können. Die Zuordnung von Kosten zu Einzelverbrauchern, Anlagensystemen und Maschinen sind spezifisch abrechenbar. Gleichzeitig ist damit ein Instrument für eine individuelle Beurteilung der einzelnen Verbraucher gegeben. Damit ist insbesondere in Gewerbe- und Büroeinrichtungen die nutzerspezifische Zuordnung der Energiekosten möglich. Eine detaillierte und zuordenbare Kostenerfassung ist bei der Maschinenverschleißermittlung, in Messarealen, in Freizeit- und Hotelbereichen, in elektrischen Energietankstellen für Land- und Wasserfahrzeuge, in Marktbereichen und in Campinganlagen möglich.
Die Einrichtungen verfügen weiterhin über wenigstens eine Schnittstelle, mit der unter anderem bidirektional Messdaten, Gerätenummern, Spitzenverbrauch, Tarife und Kosten übertragbar sind.
Die erfindungsgemäßen Einrichtungen zeichnen ich weiterhin durch seinen lageunabhängigen Betrieb aus.
Ein weiterer Vorteil besteht darin, dass diese auch so ausgestaltbar sind, dass über galvanisch von der Messelektronik getrennte Ein- und Ausgänge eine externe Ablesbarkeit möglich ist.

Die Verfahren zur Fehlerkorrektur von Einrichtungen zur Messung des fließenden elektrischen Stromes in mindestens einem elektrischen Leiter, der mit wenigstens einem elektrischen Verbraucher verbunden ist, und wobei die Messwerte in eine dem Messwert äquivalente elektrische Impulsfolge gewandelt werden, zeichnen sich vor allem dadurch aus, dass ein ihn zugrundeliegender Messfehler korrigierbar ist.
Dabei wird in einem Speicher wenigstens eine Korrekturtabelle zur Korrektur eines möglichen Fehlerfensters eingeschrieben. Durch Anlegen eines virtuellen Wertes, z.B. der Leistung, mittels eines Kalibrators wird ein definierter Arbeitspunkt der Einrichtung festgelegt, bei der die fehlerbehaftete Einrichtung eine Ausgangsimpulsfolge abgibt, die im Fehlerfenster liegt.
Anhand einer vorliegenden inneren Zeitbasis wird die fehlerhafte Größe der Impulsfolge gezählt und mit einer in dem Speicher vorgegebenen den Fehler gleich Null entstehenden Impulsfolge intern verglichen. Das Ergebnis dieses Vergleichs bewirkt in der Steuer- und Verarbeitungseinrichtung die Adressierung eines nächst günstigen oder den Fehlerkorrekturwert. Dieser wird in ein Korrekturregister der Steuer- und Verarbeitungseinrichtung implementiert. Durch dieses Verfahren ist eine selbstlernende und automatische Kalibrierung von vorhandenen Fehlern gegeben. Mit diesem Verfahren lässt sich eine Serienfertigung vollständig automatisieren, so dass ökonomisch günstig kalibrierte erfindungsgemäße Einrichtungen fertigbar sind.

Vorteilhafte Ausgestaltungen der Erfindung sind in den Patentansprüchen 2 bis 6, 8 und 9 angegeben.

Die Weiterbildungen der Patentansprüche 2 und 8, wobei die Anordnung mit dem mindestens einen elektrischen Leiter und einem Bezugspotenzial in Form z.B. des Nullleiters so zusammengeschaltet ist, dass eine Anordnung vorhanden ist,
- die neben dem elektrischen Strom gleichzeitig die Messung der anliegenden elektrischen Spannung ermöglicht und
- die weiterhin eine die Messwerte des fließenden elektrischen Stromes und der dazu anliegenden elektrischen Spannungen in äquivalente elektrische Impulsfolgen der Leistung wandelt.
Mit dem niederohmigen Messwiderstand, der Anordnung, der Steuer- und Verarbeitungseinrichtung und der Stromversorgungseinrichtung ist vorteilhafterweise ein elektronischer Energiezähler gegeben.

Die Weiterbildung des Patentanspruchs 3 führt zu einer Einrichtung mit einer oder mehrerer Tabellen mit Fehlerkorrekturwerten zur Korrektur eines möglichen Fehlerfensters der Anordnung im Speicher der Steuer- und Verarbeitungseinrichtung. Diese Einrichtungen besitzen eine selbstlernende Struktur, die eine automatische Kalibrierung ermöglicht.

Eine Verteilung der zu unterdrückenden Impulse über den gesamten Bereich des Messintervalls nach den Weiterbildungen der Patentansprüche 4 und 9 führt zu einer Verkürzung des Zeitraums bei der Fehlerkorrektur. Für einen sehr kurzen Zeitabschnitt und kleinen Fehlerstrom würde man ansonsten einen unkorrigierten Wert erhalten. Gleichzeitig sinkt die Zeit für die Kalibrierung der Einrichtungen während der Inbetriebnahme und Kalibrierung. Die Fertigungszeit wird wesentlich gesenkt und damit die Verweildauer der Messanlage mit hoher Abschreibungsrate, die schließlich den Preis des Zählers erhöht.

Die Anordnung aus den Analog-Digital-Umsetzern, dem digitalen Multiplizierer und dem Leistungs-Frequenz-Wandler nach der Weiterbildung des Patentanspruchs 5 liefert eine dem aktuellen Leistungswert äquivalente weiterverarbeitbare Impulsfolge. Diese ist voll elektronisch ausgeführt und damit lageunabhängig betreibbar.

Mit mehreren der Zahl der elektrischen Leiter zu wenigstens einem Verbraucher entsprechenden niederohmigen Messwiderständen, wobei jeweils ein niederohmiger Messwiderstand mit einer Anordnung verbunden und die Anordnungen mit einer Verarbeitungseinheit zusammengeschaltet sind, nach der Weiterbildung des Patentanspruchs 6 ist ein fehlerkorrigierter und kalibrierbarer elektronischer Energiezähler für Mehrphasennetze vorhanden.

Ausführungsbeispiele der Erfindung sind in den Zeichnungen dargestellt und werden im folgenden näher beschrieben.
Es zeigen:
- Fig. 1: ein Blockschaltbild einer Einrichtung als elektronischer Energiezähler für Einphasennetze und
- Fig. 2: ein Blockschaltbild einer Einrichtung als elektronischer Energiezähler für Dreiphasennetze.

In den folgenden Ausführungsbeispielen werden sowohl Einrichtungen als elektronische Energiezähler für Ein- und Mehrphasennetze als auch Verfahren zur Kalibrierung und Fehlerkorrektur zusammen näher erläutert.

### 1. Ausführungsbeispiel

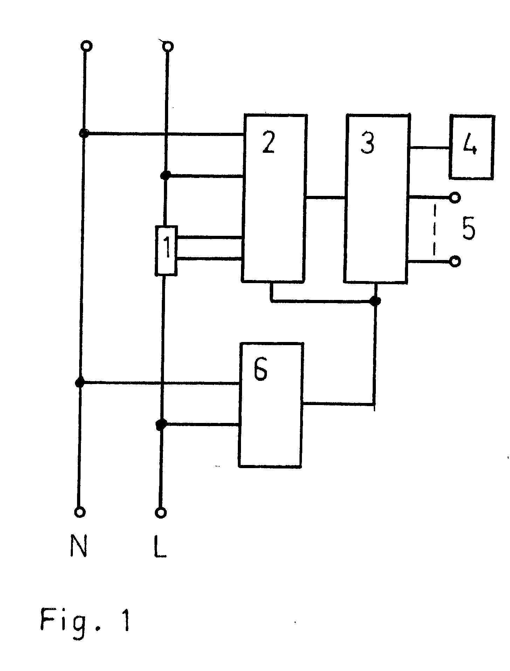

Eine Einrichtung als elektronischer Energiezähler für Einphasennetze besteht in einem ersten Ausführungsbeispiel aus den Grundbestandteilen
- eine Anordnung 2 mit einem mit der elektrischen Leiter/Phase L und dem Nullleiter N verbundenen ersten Analog-Digital-Umsetzer, einem mit zwei Abgriffen zur Abnahme des stromäquivalenten Spannungsabfalls eines im Stromleiter geschalteten niederohmigen Messwiderstands 1, der an seinen beiden Abgriffen eine stromproportionale Spannung abgibt, wobei dieser vorteilhafterweise eine niederohmige Quelle ist und von magnetischen und thermischen Störbeeinflussungen unempfindlich wirkt, verbundenen zweiten Analog-Digital-Umsetzers oder auch einer Stromwandlerschaltung, deren Ausgangsspannung proportional des fließenden Stromes ist, einem den Analog-Digital-Umsetzern nachgeschalteten digitalen Multiplizierer oder einen anderen Schaltungsanordnung, bei der die Ausgangsspannung des ersten Analog-Digital-Umsetzers die Referenzspannung des zweiten Analog-Digital-Umsetzers bildet und sonst die Multiplikation der beiden Messfaktoren durchführt und einem Leistungs-Frequenz-Wandler,
- einer Steuer und Verarbeitungseinrichtung 3 z.B. in Form eines Mikrorechner, Mikrocontrollers oder einer programmierbaren Logik mit mindestens einem Speicher,
- einer Anzeigeeinrichtung 4,
- mindestens einer Schnittstelle 5 und
- einer Stromversorgungseinrichtung 6.
Die Anordnung 2 zur Messung der aktuellen Spannung und des zeitgleich fließenden elektrischen Stromes, der Multiplikation und der Leistungs-Frequenz-Wandlung ist bekannt. Die Analog-Digital-Umsetzer, der Multiplizierer und der Leistungs-Frequenz-Wandler sind dabei im wesentlichen Bestandteile eines elektronischen Bauelements in Form eines elektronischen Schaltkreises, auf dessen Chip die wesentlichen Funktionen untergebracht sind. In der Fig. 1 sind dementsprechend diese Bestandteile als eine Anordnung 2 dargestellt.
Der Ausgang der Anordnung 2 ist mit der Steuer- und verarbeitungseinrichtung 3 verbunden.
Dabei handelt es sich vorteilhafterweise um einen 8-Bit-Mikrorechner mit einem RISC-Mikroprozessor in CMOS-Technologie, einem nichtflüchtigen Speicher in Form eines EEPROMs zur Datensicherung, einem flüchtigen Speicher in Form eines RAMs als Arbeitsspeicher und mehreren Ein-/Ausgängen, wobei mehrere interruptfähige Eingänge sind.
Die Anordnung 2 besitzt einen Fehler von ± 10% als Fehlerfenster, ein Fehler von 10% entspricht 1.150 bis 1.265 Impulsen. Die Steuer- und Verarbeitungseinrichtung 3 dient der Fehlerkorrektur und der Kalibrierung des jeweils aktuellen Messwerts sowie der Steuerung des Gesamtsystems. Die Impulsfrequenz entspricht einem Wert von 900.000 Impulsen/kWh abgegebener Leistung.
Im nichtflüchtigen Speicher der Steuer- und verarbeitungseinrichtung 3 sind die Korrekturtabellen zur Korrektur des möglichen Fehlerfensters eingeschrieben. Durch Anlegen einer virtuellen Leistung mittels eines Kalibrators liegt ein definitiver Arbeitspunkt des Energiezählers fest (Dauergrenzlastfaktor), bei dem der fehlerbehaftete elektronische Energiezähler eine Ausgangsimpulsfolge abgibt, die im Fehlerfenster liegt. Anhand der vorliegenden inneren Zeiteinheit wird die fehlerhafte Größe der Impulsfolge gezählt und mit einer in dem Speicher vorgegebenen dem Fehler gleich Null entstehenden Impulsfolge intern verglichen. Das Ergebnis des Vergleichs bewirkt in der Steuer- und Verarbeitungseinrichtung 3 die Adressierung des nächst günstigsten oder des Fehlerkorrekturwertes und schreibt diesen in ein Korrekturregister der Steuer- und Verarbeitungseinrichtung 3 ein. In einem zweiten Schritt kann nach Korrektur der Impulsfolge die korrigierte Impulsfolge festgestellt und nochmals geprüft werden, ob diese mit einem günstigeren Fehlerkorrekturwert weiter zu verkleinern ist.
Der Fehlerkorrekturwert ist sind alle die Impulse, die für die weitere Verarbeitung unterdrückt oder hinzugefügt werden, die in Bezug auf die genannten 900.000 Impulse/kWh zu viel oder zu wenig sind. Der Messbereich wird in n Intervalle eingeteilt. Die zu unterdrückenden Impulse werden über die n Intervalle innerhalb der Messzeit weitgehend gleichverteilt. Ansonsten würde man für einen sehr kurzen Zeitabschnitt und kleinen Fehlerstrom einen unkorrigierten Wert erhalten. Die zu unterdrückenden Impulse sind in den n-1 Intervallen gleichverteilt. Der Rest der zu unterdrückenden Impulse wird im letzten Intervall gleichverteilt unterdückt oder ergänzt.
Die Steuer- und Verarbeitungseinrichtung 3 kann in einer weiteren Ausführungsform wenigstens einer der folgenden Funktionen einzeln oder in Kombinationen dienen:
- Zum Ersten der Ansteuerung einer Schnittstelle 5 in Form z.B. einer S0-Schnittstelle und einer dazugehörigen Anzeige des elektronischen Energiezählers. Es handelt sich um ein Impulsausgänge, die synchron geschaltet werden. Ausgegeben werden 10.000 Impulse/kWh mit einem positiven Restfehler, da eine absolute Gleichverteilung der zu unterdrückenden Impulse im Sinne des oben genannten für viele Anfangsfehlerwerte im wesentlichen nicht möglich ist. Der Restfehler ist aber immer so klein, dass die Fehlerklasse eingehalten wird.
- Zum Zweiten der Ansteuerung einer Betriebsanzeige. Dazu verfügt der elektronische Energiezähler über eine Anzeige in Form einer Lumineszenzdiode. Diese dient der Anzeige ob über den elektronischen Energiezähler ein Strom fließt.
- Zum Dritten der Ansteuerung einer Anzeigeeinrichtung 4 in Form eines mechanischen Zählwerks oder eines Displays, insbesondere ein Flüssigkeitsdisplays. Es können auch mehrere Anzeigeeinrichtungen 4 alternativ angesteuert werden, so dass der elektronische Energiezähler auch als Mehrtarifzähler für mehrere Tarife realisierbar ist.
Das Impulsverhältnis zwischen dem S0- und dem Zählerausgang an der Steuer- und Verarbeitungseinrichtung 3 beträgt 1000 : 1, d.h. 1 Impuls ist äquivalent zu einer über den elektronischen Energiezähler abgegebenen Energiemenge von 0,1 kWh. Voreingestellt ist immer die Ansteuerung des Ausgangs für einen Tarif. Eine Tarifumschaltung kann über die serielle Schnittstelle 5 des elektronischen Energiezählers erfolgen.
- Zum Vierten der Speicherung und Datensicherung. Dabei können unter anderem folgende weitere Daten einzeln oder in Kombinationen gespeichert werden:
   - die Gerätenummer einschließlich der Jahreszahl,
   - der Zählerstand mehrerer Tarife,
   - der aktuell geschaltete Tarif,
   - den auf ein periodisches Intervall bezogenen Maximalwert, der über den elektronischen Energiezähler abgegebenen Leistung und
   - die über einen beliebig gewählten Zeitraum abgegebene Leistung, die separat von der Tarifzählung gespeichert wird.
Im Falle eines Spannungsausfalls müssen alle wichtigen Daten im Speicher stehen, so dass diese nicht verloren gehen. Deshalb werden die zu sichernden Daten immer dann gespeichert, wenn eine Wertänderung erfolgte. Weiterhin wird die Spannung über einen kurzen Zeitraum gepuffert. Der Zeitraum reicht dabei aus, um die Werte, die sich möglicherweise gleichzeitig geändert haben, zu sichern.
In einer weiteren Variante des elektronischen Energiezählers zum Fünften der Tarifumschaltung, der Maximalwertbestimmung und zeitbezogenen Energiemessung. Die Umschaltung von einem zum anderen Tarif erfolgt softwaregesteuert über Befehle, die die Steuer- und Verarbeitungseinrichtung 3 über die serielle Schnittstelle 5 erhält. Ebenso wird die Maximalwertbestimmung der über ein periodisches Messintervall und die Ein-/Ausschaltung der zeitbezogenen Erfassung der über den elektronischen Energiezähler abgegebenen Energie über die serielle Schnittstelle 5 gesteuert. Auf Anforderung kann der elektronische Energiezähler die gespeicherten Zählerwerte über diese Schnittstelle 5 senden.
In einer weiteren Variante können zum Sechsten auch weitere Schnittstellen 5 vorhanden sein, wie z.B. M-Bus, Z-Bus, RS 485 und/oder Powerline.

Die Stromversorgungseinrichtung 6 für den elektronischen Energiezähler besitzt einen Transformator oder ist als C- Netzteil ausgeführt. Beide Varianten sind bekannt.
Die Messung des fließenden elektrischen Stromes erfolgt über einen bekannten niederohmigen Messwiderstand 1, der in den Leiter/die Phase L zum Verbraucher geschalten ist.

### 2. Ausführungsbeispiel

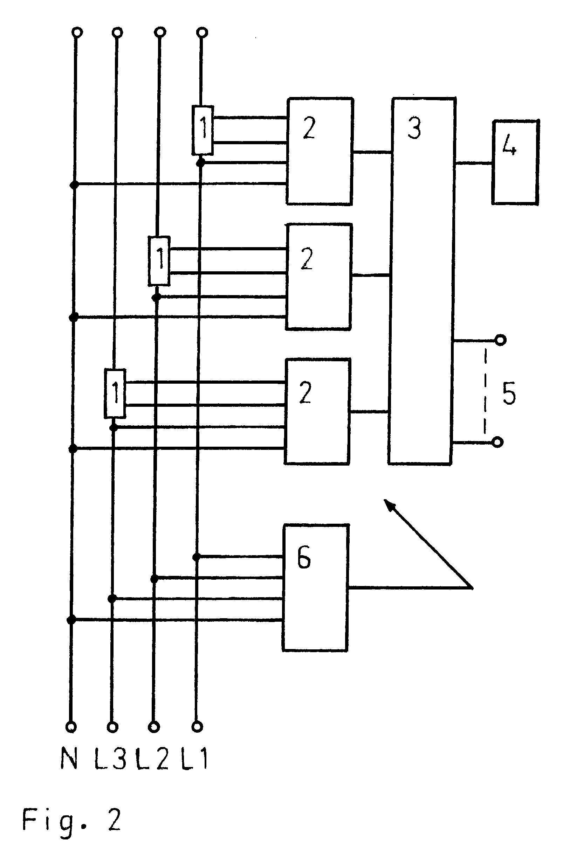

Eine Einrichtung als elektronischer Energiezähler für Dreiphasennetze besteht in einem zweiten Ausführungsbeispiel entsprechend der Darstellung in der Fig. 2 aus den Grundbestandteilen von drei gleiche Anordnungen 2 zur Strom- und Spannungsmessung in dem jeweiligen Leiter/der jeweiligen Phase L1, L2, L3, Bildung des Produkts und des Integrals über die Messzeit und Erzeugung einer der übertragenden elektrischen Arbeit proportionalen Impulsfolge, einer Steuer- und Verarbeitungseinrichtung 3, insbesondere einem Mikrorechner, einem Mikrocontroller, einer programmierbaren Logik, mit wenigstens einen Speicher, einer Anzeigeeinrichtung 4, mindestens einer Schnittstelle 5 und einer Stromversorgungseinrichtung 6.
Die drei gleiche Anordnungen 2 als Messsysteme, wobei jede Anordnung 2 ohne galvanische Trennung in dem jeweiligen Leiter/der jeweiligen Phase L1, L2, L3 die Strom- und Spannungsmessung ausführt, das Produkt bildet, das Integral über die Messzeit bildet und eine der übertragenden elektrischen Arbeit proportionalen Impulsfolge mit entsprechenden linearen später zu korrigierenden Messfehler bis zu ± 10% erzeugt. Diese drei gleichartigen Messwertverarbeitungen werden aus der jeweiligen Phase durch die Stromversorgungseinrichtung 6 mit elektrischer Energie versorgt. Die Messwerte in Form einer Impulsfolge werden über einen Optokoppler galvanisch getrennt der Steuer- und Verarbeitungseinrichtung 3, der auf Bezugsbasis Nullleiter N arbeitet, jeweils an einem interruptfähigen Eingang zugeführt und in diesem System wie im ersten Ausführungsbeispiel dargestellt und beschrieben dreikanalig mit dem jeweiligem Korrekturfaktor korrigiert, summiert und für Anzeigeeinrichtungen 4, Zählwerke und Datenschnittstellen 5 entsprechend des ersten Ausführungsbeispiels aufbereitet. Damit ist für jedes der drei Messsysteme ein nichtverlustiger Speicher für die wichtigsten Betriebsdaten und Steueralgorithmen enthalten.
Die Stromversorgungseinrichtung 6 für diesen elektronischen Energiezähler in Dreiphasensystemen ist in bekannterweise entweder in einer ersten Ausführungsform mit einem Transformator oder mehreren Transformatoren versehen oder in einer zweiten Ausführungsform transformatorlos als C- Netzteil ausgeführt.
Die Messung des fließenden elektrischen Stromes zum Verbraucher erfolgt über niederohmige Messwiderstände 1. Diese befinden sich in den Leitern/Phasen L1, L2, L3 zum Verbraucher. Die Realisierung und der Aufbau der niederohmigen Messwiderstände 1 ist bekannt.

## Patentansprüche

1. Einrichtung zur Messung des fließenden elektrischen Stromes in mindestens einem elektrischen Leiter, der mit wenigstens einem elektrischen Verbraucher verbunden ist, mit folgenden Merkmalen:
- einem in den elektrischen Leiter (L) zum elektrischen Verbraucher geschalteten niederohmigen Messwiderstand (1),
- einer mit dem niederohmigen Messwiderstand (1) verbundenen, den im elektrischen Leiter (L) fließenden elektrischen Strom damit messenden und diese Messwerte in äquivalente elektrische Impulsfolgen wandelnden Anordnung (2),
- einer zum Ersten mit der Anordnung (2) verbundenen,
- zum Zweiten die elektrische Impulsfolge in wenigstens einen Messintervall zählenden, den Messfehler als Anzahl von Impulsen aus einer gespeicherten und vorgegebenen Mehrzahl entsprechend eines bei der Kalibrierung mittels eines Kalibrators in wenigstens einem Messintervall gleich Null, annähernd gleich Null oder auf das Minimum setzenden und diese Anzahl von Impulsen oder die Adresse mit dieser Anzahl in ein Register zur Korrektur eines möglichen Fehlerfensters einschreibenden oder adressierenden, diese Anzahl von Impulsen des Messfehlers bei aktuellen Messungen im Messintervall zuordnenden und bei Abweichungen durch Unterdrückung oder Ergänzung der eingeschriebenen oder adressierten Impulsfolge im Messintervall korrigierenden,
zum Dritten die Messintervalle aufsummierenden und
zum Vierten diese Summe nach vorgegebenen Merkmalen zuordnenden Steuer- und Verarbeitungseinrichtung (3).

2. Einrichtung nach Patentanspruch 1, **dadurch gekennzeichnet, dass** die Anordnung (2) mit dem mindestens einen elektrischen Leiter (L) und einem Bezugspotential/Nullleiter (N) so zusammengeschaltet ist, dass das eine neben dem elektrischen Strom gleichzeitig die anliegende elektrische Spannung messende Anordnung (2) ist, dass das weiterhin eine die Messwerte des fließenden elektrischen Stromes und der dazu anliegenden elektrischen Spannungen in äquivalente elektrische Impulsfolgen der Leistung wandelnde Anordnung (2) ist und dass der niederohmige Messwiderstand (1), die Anordnung (2), die Steuer- und Verarbeitungseinrichtung (3) und die Stromversorgungseinrichtung (6) ein elektronischer Energiezähler ist.

3. Einrichtung nach Patentanspruch 1 oder den Patentansprüchen 1 und 2, **dadurch gekennzeichnet, dass** die Steuer- und Verarbeitungseinrichtung (3) eine oder mehrere Tabellen mit Fehlerkorrekturwerten zur Korrektur eines möglichen Fehlerfensters der Anordnung (2) in einem Speicher enthält, wobei entsprechend einer Zeitbasis die fehlerhafte Größe der Impulsfolge gezählt, mit einer im Speicher vorgegebenen dem Fehler gleich Null entstehenden Impulsfolge verglichen, der günstigste oder ein nächst günstigster Fehlerkorrekturwert adressiert und dieser Fehlerkorrekturwert in ein Korrekturregister der Steuer- und Verarbeitungseinrichtung (3) eingeschrieben wird.

4. Einrichtung nach Patentanspruch 1 oder den Patentansprüchen 1 und 2, **dadurch gekennzeichnet, dass** das Messintervall in n Unterintervalle aufgeteilt ist, dass die zu unterdrückenden oder zu ergänzenden Impulse in den n-1 Unterintervallen und dass der Rest der zu unterdrückenden oder zu ergänzenden Impulse insbesondere im letzten Unterintervall gleichverteilt sind.

5. Einrichtung nach Patentanspruch 1, **dadurch gekennzeichnet, dass** die Anordnung (2) aus einem mit dem Leiter/der Phase (L) und dem Nullleiter (N) verbundenen ersten Analog-Digital-Umsetzer, einem mit zwei Abgriffen eines in die Phase geschalteten niederohmigen Messwiderstandes (1) verbundenen zweiten Analog-Digital-Umsetzers, einem den Analog-Digital-Umsetzern nachgeschalteten digitalen Multiplizierer und Leistungs-Frequenz-Wandler besteht.

6. Einrichtung nach Patentanspruch 1, **dadurch gekennzeichnet, dass** bei mehreren elektrischen Leitern (L1, L2, L3) zu wenigstens einem Verbraucher jeweils ein niederohmiger Messwiderstand (1) in einen elektrischen Leiter (L1, L2, L3) geschalten ist, dass jeweils ein niederohmiger Messwiderstand (1) mit einer Anordnung (2) verbunden ist und dass die Anordnungen (2) mit einer Steuer- und Verarbeitungseinrichtung (3) zusammengeschaltet sind.

7. Verfahren zur Kalibrierung und Fehlerkorrektur von Einrichtungen zur Messung des fließenden elektrischen Stromes in mindestens einem elektrischen Leiter, der mit wenigstens einem elektrischen Verbraucher verbunden ist, und wobei die Messwerte in eine dem Messwert äquivalente elektrische Impulsfolge gewandelt werden, mit folgenden Schritten:
- Zählung der elektrischen Impulsfolge und Feststellung des Fehlers der Einrichtung innerhalb eines Messintervalls mit einer Referenzquelle in wenigstens einem Messbereich und entsprechend einer Zeitbasis,
- Vergleich mit einer in einem Speicher der Einrichtung vorgegebenen dem Fehler gleich Null entstehenden Impulsfolge,
- Adressierung des günstigsten oder eines nächst günstigsten Fehlerkorrekturwertes aus wenigstens einer Tabelle mit Fehlerkorrekturwerten zur Korrektur eines möglichen Fehlerfensters von Bestandteilen der Einrichtung und
- Einschreiben dieses Fehlerkorrekturwertes in ein Korrekturregister einer Steuer- und Verarbeitungseinrichtung (3) der Einrichtung.

8. Verfahren nach Patentanspruch 7, **dadurch gekennzeichnet, dass** in einer Anordnung (2) über einen niederohmigen Messwiderstand (1) in wenigstens einen elektrischen Leiter (L) der fließende elektrische Strom zu einem elektrischen Verbraucher und die gegenüber einem Bezugspotential/Nullleiter (N) anliegende elektrische Spannung gemessen und die Messwerte des fließenden elektrischen Stromes und der dazu anliegenden elektrischen Spannung in äquivalente elektrische Impulsfolgen der Leistung gewandelt werden, dass die elektrischen Impulsfolgen gezählt und der Fehler innerhalb eines Messintervalls der Einrichtung gegenüber einer Referenzeinrichtung in wenigstens einem Messbereich ermittelt wird, dass der Messfehler mit einer in einem Speicher der Einrichtung vorgegebenen dem Fehler gleich Null entstehenden Impulsfolge verglichen wird, dass dieser Wert des Fehlers des günstigsten oder eines nächst günstigsten Fehlerkorrekturwertes aus wenigstens einer Tabelle mit Fehlerkorrekturwerten zur Korrektur eines möglichen Fehlerfensters von Bestandteilen der Einrichtung adressiert wird, dass dieser Fehlerkorrekturwert in ein Korrekturregister einer Steuer- und Verarbeitungseinrichtung (3) der Einrichtung eingeschrieben wird und dass die Impulse des Fehlerkorrekturwertes bei aktuellen Messwerten innerhalb des Messintervalls bei Betrieb unterdrückt werden.

9. Verfahren nach einem der Patentansprüche 7 oder 8, **dadurch gekennzeichnet, dass** das Messintervall in n Unterintervalle aufgeteilt wird, dass die zu unterdrückenden oder zu ergänzenden Impulse in den n-1 Unterintervallen gleichverteilt sind und dass der Rest der zu unterdrückenden oder zu ergänzenden Impulse insbesondere im letzten Unterintervall erfolgt.
